# EUROPEAN PATENT SPECIFICATION

(11) **EP 3 193 543 B1**
(45) Date of publication and mention of the grant of the patent: **19.06.2019**
(21) Application number: 14901787.3
(22) Date of filing: 10.12.2014
(51) Int. Cl.: H04W 52/00, H03G 3/00, H03G 3/30

(54) **SIGNAL GAIN CONTROL METHOD AND DEVICE AND STORAGE MEDIUM**
SIGNALVERSTÄRKUNGSVERFAHREN UND -VORRICHTUNG UND SPEICHERMEDIUM
PROCÉDÉ ET DISPOSITIF DE COMMANDE DE GAIN DE SIGNAL ET SUPPORT D'INFORMATIONS

(30) Priority: 10.09.2014 CN 201410459586
(43) Date of publication of application: 19.07.2017
(73) Proprietor: ZTE Corporation, Shenzhen, Guangdong 518057 (CN)
(72) Inventor: WANG, Liehu, Shenzhen Guangdong 518057 (CN); LI, Congwei, Shenzhen Guangdong 518057 (CN); LI, Xiaofei, Shenzhen Guangdong 518057 (CN)
(74) Representative: Brevalex
(86) International application number: PCT/CN2014/093464
(87) International publication number: WO 2016/037429

(56) References cited:
- CN-A- 1 705 238
- CN-A- 1 719 751
- CN-A- 102 231 906
- US-A- 5 917 865
- US-B1- 6 459 727

## Description

### TECHNICAL FIELD

The disclosure relates to signal processing technology in mobile communications, and in particular to a signal gain control method and device, and a storage medium.

### BACKGROUND

A distributed base station in a mobile communication system is mainly composed of a Base Band Unit (BBU) and a Radio Remote Unit (RRU). An uplink function of the base station is mainly: receiving through an antenna a signal transmitted by a mobile terminal from the air, amplifying the received signal and then mixing it to a lower frequency, converting an analogue signal into a digital signal through an Analogue to Digital Converter (ADC), and finally sending the signal to the BBU after a series of digital Intermediate Frequency (IF) processing.

The dynamic range of the ADC in an uplink receiving link is fixed, and may not satisfy the dynamic receiving range of a receiver. In addition, a Radio Frequency (RF) device in the uplink receiving link deteriorates a noise factor, besides, there are saturation and intermodulation points like 1dB compression point and third-order intermodulation intercept point. Thus, in order to satisfy the dynamic receiving range of the receiver and improve the anti-jamming capability of the receiver, it is required to perform gain control on an output signal of an RF link. The basic idea of gain control is: the gain of the receiver is increased when the receiver receives a weak signal, and the gain of the receiver is reduced when the receiver receives a strong signal, so that the output signal keeps at a proper level. The receiver can work normally even if the output signal is too weak, and receiver will not be saturated or jammed even if the output signal is too strong.

At present, rapid control method and slow control method are usually used to perform gain control on an uplink signal of the base station. The rapid control is calculating an instantaneous power of a sampled signal after Analogue to Digital Conversion (ADC), and when the number of times that the instantaneous power of the sampled signal after ADC is greater than a pre-set threshold number of times, immediately performing gain adjustment on an IF Variable Gain Amplifier (VGA) and an RF attenuator. The slow control is calculating an average power of a sampled signal after ADC during a certain period of time of the current time slot of the current frame, performing gain adjustment on the IF VGA and the RF attenuator according to a power detection result and the pre-set threshold, and performing gain configuration in a time slot corresponding to the next frame.

However, the above gain control policies have the following disadvantages: (1) when the average power is taken as the basis of gain adjustment, it is difficult to determine a gain control threshold of a Time Division Duplexing (TDD) system, and the requirement of the TDD system cannot be met; (2) when the average power is taken as the basis of gain adjustment and when there is a time division interference (for example, the Distance Measuring Equipment (DME) interference commonly seen in a mobile transceiver), it is difficult to determine the gain control threshold of the TDD system, and it is unable to deal with the time division interference effectively; and (3) it is only applied to the gain adjustment on a wireless base station in a certain specific system or specification, so its universality is low.

US 6459727 B1 discloses a very high digital subscriber line (VDSL) receiver, and a programmable gain amplifier (PGA) and a narrow-band noise remover thereof.

US 5917865 A discloses a method for determining a magnitude of the gain signal, for use in an automatic gain control that receives a digital signal from a digital circuit having a given dynamic range and develops therefrom a gain signal to be applied to a variable gain amplifier.

CN 102231906 A discloses a rapid gain control method and a slow gain control method.

### SUMMARY

In view of this, the disclosure is intended to provide a signal gain control method and device, and a storage medium, which can satisfy the receiving range and anti-jamming capability of wireless base stations with various application systems and specifications, thereby effectively dealing with a time division interference.

The technical solutions of the disclosure are implemented as follows.

A signal gain control method is provided, which includes that: gain control parameters are determined; peaks of output signals of an ADC are detected in a rapid attenuation peak search window and a slow control peak search window respectively; and the detected peaks are compared with thresholds in the gain control parameters, and gain control is performed on the signals according to the comparison results.

The thresholds in the gain control parameters include any one or more of a rapid attenuation threshold, a slow attenuation threshold, a slow call-back threshold and a slow call-back target threshold; that the detected peaks are compared with the thresholds in the gain control parameters includes that:
in the rapid attenuation peak search window, the detected real-time peak is compared with the rapid attenuation threshold; and/or, in the slow control peak search window, the detected real-time peak is compared with the slow attenuation threshold; and/or, in the slow control peak search window, the detected maximum peak is compared with the slow call-back threshold and the slow call-back target threshold.

Gain control is performed on the signals according to the comparison results includes that: when the detected real-time peak is greater than the rapid attenuation threshold, one is added to the cumulative number of excessively rapid attenuation thresholds; when the cumulative number of excessively rapid attenuation thresholds is equal to a threshold of the number of rapid attenuations, a rapid attenuation is performed according to a rapid attenuation step; and/or, when the detected real-time peak is greater than the slow attenuation threshold, one is added to the cumulative number of excessively slow attenuation thresholds; when the cumulative number of excessively slow attenuation thresholds is greater than a threshold of the number of slow attenuations, and the rapid attenuation is not performed in the control period at the end of the slow control peak search window, a slow control attenuation value is calculated according to a slow attenuation step, and a slow control is performed at the start of the next control period; and/or, when the detected maximum peak is less than or equal to the slow call-back threshold, the slow control attenuation value is calculated according to a slow call-back step in the gain control parameters, and the slow control is performed at the start of the next control period; and/or, when the maximum peak detected in continuous N control periods is greater than the slow call-back threshold, and is less than or equal to the slow call-back target threshold, the slow control attenuation value is calculated according to a super slow call-back step in the gain control parameters, and the slow control is performed at the start of the next control period, where N is a positive integer which is greater than or equal to 2.

In an embodiment, that the gain control parameters are determined includes that: when a base station is powered up or the configuration of a base station changes, the gain control parameters matching with an application system of the base station is selected from the pre-stored gain control parameters according to the configuration of the base station.

In an embodiment, the method further includes that: gain adjustment amount is compensated by delaying.

A signal gain control device is also provided, which includes: a determining module, a detecting module, a comparing module and a gain control module; where,
the determining module is configured to determine the gain control parameters;
the detecting module is configured to detect the peaks of the output signals of the ADC in the rapid attenuation peak search window and the slow control peak search window respectively;
the comparing module is configured to compare the detected peaks with the thresholds in the gain control parameters; and
the gain control module is configured to perform gain control on the signals according to the comparison results.

The thresholds in the gain control parameters include any one or more of the rapid attenuation threshold, the slow attenuation threshold, the slow call-back threshold and the slow call-back target threshold;
the comparing module is configured to, in the rapid attenuation peak search window, compare the detected real-time peak with the rapid attenuation threshold; and/or, in the slow control peak search window, compare the detected real-time peak with the slow attenuation threshold; and/or, in the slow control peak search window, compare the detected maximum peak with the slow call-back threshold and the slow call-back target threshold.

The gain control module is configured to, when the detected real-time peak is greater than the rapid attenuation threshold, add one to the number of first excessively peaks, and when the first excessively peak is equal to a threshold of the number of rapid attenuations, perform a rapid attenuation according to the rapid attenuation step; and/or when the detected real-time peak is greater than the slow attenuation threshold, add one to the number of second excessively peaks, and when the second excessively peak is greater than the threshold of the number of slow attenuations, and the rapid attenuation is not performed in the control period at the end of the slow control peak search window, calculate the slow control attenuation value according to the slow attenuation step, and perform the slow control at the start of the next control period; and/or when the detected maximum peak is less than or equal to the slow call-back threshold, calculate the slow control attenuation value according to the slow call-back step in the gain control parameters, and perform the slow control at the start of the next control period; and/or when the maximum peak detected in continuous N control periods is greater than the slow call-back threshold, and is less than or equal to the slow call-back target threshold, calculate the slow control attenuation value according to the super slow call-back step in the gain control parameters, and perform the slow control at the start of the next control period, where N is a positive integer which is greater than or equal to 2.

In an embodiment, the determining module is configured to, when the base station is powered up or the configuration of the base station changes, select the gain control parameters matching with the application system of the base station from the pre-stored gain control parameters according to the configuration of the base station.

In an embodiment, the device further includes: a compensating module, which is configured to compensate the gain adjustment amount by delaying.

A computer storage medium is also provided, in which a computer executable instruction is stored; the computer executable instruction is used for performing the signal gain control method.

According to the signal gain control method and device, and the storage medium provided by the disclosure, the gain control parameters are determined, the peaks of the output signals of the ADC are detected in the rapid attenuation peak search window and the slow control peak search window respectively; the detected peaks are compared with the thresholds in the gain control parameters, and the gain control is performed on the signals according to the comparison results. In the embodiments of the disclosure, by taking a peak power as the basis of gain adjustment, a Peak-to-Average Ratio (PAR) of a signal, a time-domain characteristic of an interference signal and a time division characteristic of a TDD signal have less influence on an Automatic Gain Control (AGC) threshold, which is beneficial for determining and unifying each control threshold; by pre-storing the optimal gain control parameter of the baes stations with various application systems, and when the base station is powered on or the configuration of the base station changes, selecting the gain control parameters matching with the application system of the base station from the pre-stored gain control parameters according to the configuration of the base station, the signal gain control method of the disclosure can satisfy the receiving range and anti-jamming capability of wireless base stations with various application systems and specifications, thereby effectively dealing with the time division interference.

### BRIEF DESCRIPTION OF THE DRAWINGS

Fig. 1 is a basic flowchart of a signal gain control method according to an embodiment of the disclosure;
Fig. 2 is a schematic diagram of partitioning a control period and a time slot according to an embodiment of the disclosure;
Fig. 3 is a schematic diagram of gain control containing a GSM mode according to an embodiment of the disclosure;
Fig. 4 is a schematic diagram of gain control without a GSM mode according to an embodiment of the disclosure;
Fig. 5 is a schematic diagram of a relationship between a control threshold and a gain control policy according to an embodiment of the disclosure;
Fig. 6 is a detailed flow of a signal gain control method according to an embodiment of the disclosure;
Fig. 7 is a structure diagram of a signal gain control device according to an embodiment of the disclosure; and
Fig. 8 is a structure diagram of a base station using a signal gain control device according to an embodiment of the disclosure.

### DETAILED DESCRIPTION

In the embodiments of the disclosure, gain control parameters are determined; peaks of output signals of an ADC are detected in a rapid attenuation peak search window and a slow control peak search window respectively; and the detected peaks are compared with thresholds in the gain control parameters, and gain control is performed on the signals according to the comparison results.

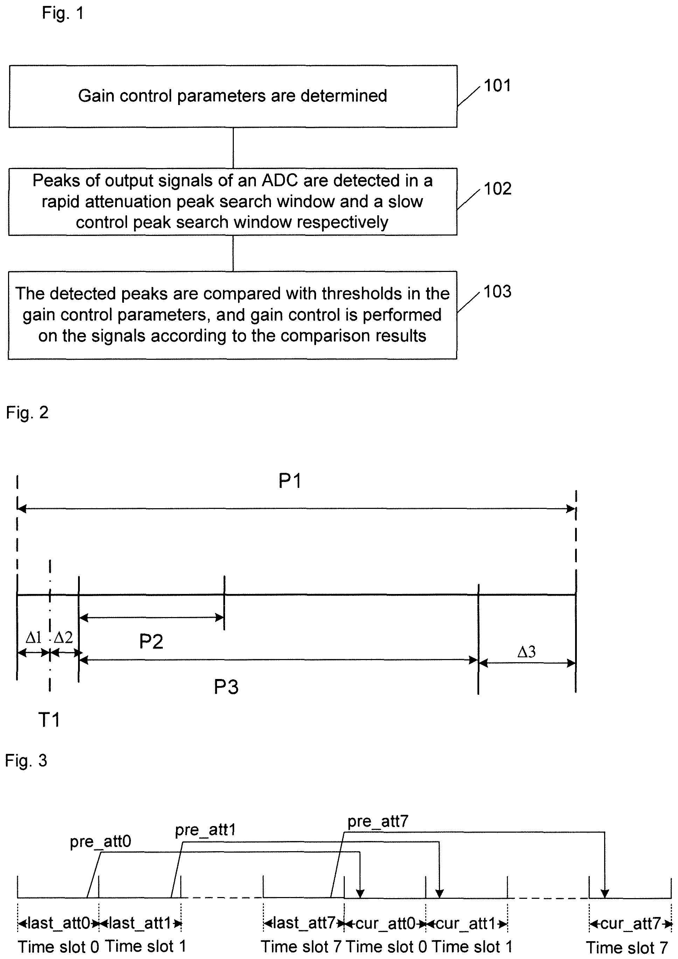

As shown in Fig. 1, the basic processing flow of the signal gain control method provided by the embodiment of the disclosure includes the following steps.

At Step 101: the gain control parameters are determined.

Specifically, a data IF processor pre-stores the optimal gain control parameters of the base stations for various application systems. When the base station is powered on or the configuration of the base station changes, the gain control parameters matching with the application system of the base station is selected from the pre-stored optimal gain control parameters according to the configuration of the base station.

Here, the application systems of the base stations include: Global System for Mobile Communication (GSM), Universal Mobile Telecommunications System (UMTS), Code Division Multiple Access (CDMA), Time Division-Long Term Evolution (TD-LTE), TD-CDMA, Frequency Division Duplexing (FDD) LTE and various mixed systems. The gain control parameters include: a gain control mode, a control period, a control threshold, an adjusting step, a gain control policy, a cumulative number, adjustment time, and so on.

There are three control periods. The first control period is applied to a time division structure of a GSM system, and lasts 577us. The second control period is applied to other FDD system except the GSM system, and can be configured as an integral multiple of a subframe. The third control period is applied to the TDD system or a system with the time division interference, and can be configured as an integral multiple of a radio frame. Fig. 2 shows a schematic diagram showing partition of the control periods and the periods of time; the control period P1 is determined according to the application system and specification of a wireless base station. The length of the rapid attenuation peak search window P2 and the slow attenuation peak search window P3 are determined according to both the length of the control period P1 and the application system of the wireless base station. An AGC system performs condition judgement of rapid attenuation control and gain configuration in the period of time P2, and performs condition judgement of slow control and super slow call-back control in the period of time P3. The time T1 is the time for performing the slow control and the super slow call-back control. The period of time Δ1 is used for calculating the current attenuation amount of each control period, the period of time Δ2 is device response time which is set according to the characteristic of a device and a transmission speed of a transmission interface, and the period of time Δ3 is used for calculating the attenuation amount of the next control period corresponding to the current control period and storing time. For the FDD LTE system, P1, P2, P3, Δ1, Δ2 and A3 can be set as 1ms, 0.1ms, 0.9ms, 0.002ms, 0.005ms, and 0.093ms respectively.

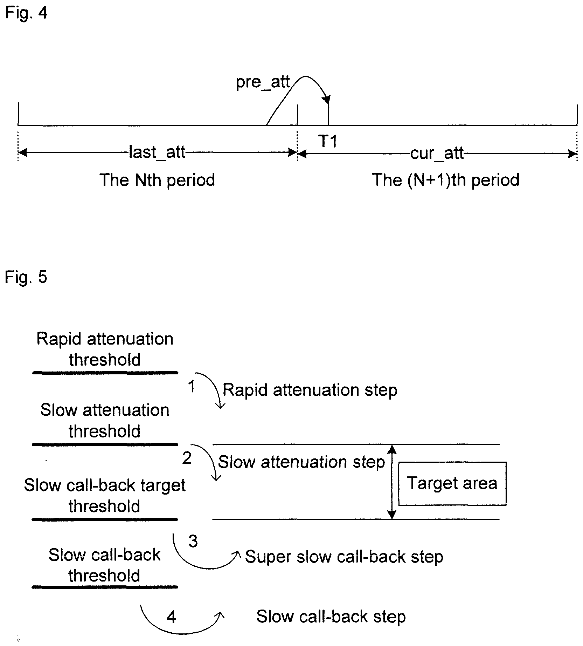

There are two control modes; the first control mode is the mode containing GSM, and is applied to the GMS system and a mixed mode system containing the GSM system. The schematic diagram of gain control of the mode containing GSM is shown in Fig. 3. The mode containing GSM makes the slow control or the super slow call-back attenuation amount that are calculated in the current time slot of the current Time Division Multiple Access (TDMA) take effect after making them correspond to the corresponding time slot of the next TDMA frame. The second control mode is the mode without GSM, and is applied to a single mode or mixed mode system for non-GMS. The schematic diagram of gain control of the mode without GSM is shown in Fig. 4, and the control of the slow control attenuation amount is directly performed at the starting position of the control period.

The control thresholds include: a rapid attenuation threshold, a threshold of the number of rapid attenuations, a slow attenuation threshold, a threshold of the number of slow attenuations, a threshold of the number of super slow call-backs, a slow call-back target threshold and a slow call-back threshold; the rapid attenuation threshold is greater than the slow attenuation threshold, the slow attenuation threshold is greater than the slow call-back target threshold, the slow call-back target threshold is greater than the slow call-back threshold; the control thresholds include the thresholds in the gain control parameters.

The adjusting steps include: a rapid attenuation step, a slow attenuation step, a slow call-back step and a super slow call-back step.

The gain control policies include: rapid attenuation and slow control; the slow control includes: slow attenuation, slow call-back and super slow call-back.

The cumulative numbers include: the cumulative number of excessively rapid attenuation thresholds, the cumulative number of excessively slow attenuation thresholds, and the cumulative number of super slow call-back thresholds. The thresholds of the number include: the threshold of the number of rapid attenuations, the threshold of the number of slow attenuations, and the threshold of the number of super slow call-backs. The threshold of the number of rapid attenuations, the threshold of the number of slow attenuations, and the threshold of the number of super slow call-backs are determined according to the signal characteristic, so as to ensure the judgement accuracy. By calculating the cumulative number, some specific and known large interference signals can be shielded effectively.

The adjustment time includes: rapid adjustment time and slow adjustment time. The position of the rapid adjustment time in the control period is not fixed, and is specifically the time of immediately attenuating after a rapid attenuation judgement is effective. The position of the slow adjustment time in the control period is fixed, and is specifically the fixed time point after the start of each control period. The adjustment time is used for performing gain control.

At Step 102: the peaks of the output signals of the ADC are detected in the rapid attenuation peak search window and the slow control peak search window respectively.

Specifically, the data IF processor performs modulus value detection on the output signals of the ADC in the rapid attenuation peak search window and the slow control peak search window.

The rapid attenuation peak search window is a pre-set period of time which is less than the control period, and is used for peak search and peak comparison of the rapid attenuation. The slow attenuation peak search window is another pre-set period of time which is less than the control period, and is used for peak search and peak comparison of the slow attenuation.

At Step 103: the detected peaks are compared with thresholds in the gain control parameters, and the gain control is performed on the signals according to the comparison result.

The thresholds in the gain control parameters include any one or more of the rapid attenuation threshold, the slow attenuation threshold, the slow call-back threshold and the slow call-back target threshold.

Specifically, in the rapid attenuation peak search window, the data IF processor compares the detected real-time peak with the rapid attenuation threshold, and when the detected real-time peak is greater than the rapid attenuation threshold, adds one to the cumulative number of excessively rapid attenuation thresholds. When the cumulative number of excessively rapid attenuation thresholds is equal to the threshold of the number of rapid attenuations, the data IF processor performs the rapid attenuation according to the rapid attenuation step, and at the same time, the data IF processor clears the cumulative number of excessively rapid attenuation thresholds; . When the detected real-time peak is less than or equal to the rapid attenuation threshold, the data IF processor does not perform any processing.

In the slow attenuation peak search window, the data IF processor compares the detected real-time peak with the slow attenuation threshold, and when the detected real-time peak is greater than the slow attenuation threshold, adds one to the cumulative number of excessively slow attenuation thresholds. When the cumulative number of excessively slow attenuation thresholds is greater than the threshold of the number of slow attenuations, it does not perform the rapid attenuation in the control period at the end of the slow control peak search window, calculates a slow control attenuation value according to a slow attenuation step, and performs slow control at the start of the next control period. The data IF processor clears the cumulative number of excessively slow attenuation thresholds at the start of each control period.

In the slow attenuation peak search window, when the detected maximum peak is less than or equal to the slow call-back threshold, the data IF processor calculates the slow control attenuation value according to the slow call-back step in the gain control parameters, and performs the slow control at the start of the next control period.

In the slow attenuation peak search window, when the maximum peak detected in continuous N control periods is greater than the slow call-back threshold, and is less than or equal to the slow call-back target threshold, the data IF processor calculates the slow control attenuation value according to the super slow call-back step in the gain control parameters, and performs the slow control at the start of the next control period. Here N is a positive integer which is greater than or equal to 2.

When performing the rapid attenuation and slow control, the data IF processor first needs to inquire the total gain adjustment amount stored in the previous control period, and then inquires and obtains, according to a pre-stored attenuation policy table, the gain adjustment amount of each gain adjustment unit for an RF link. Specifically, a gain control module can be used in the data IF processor to perform the rapid attenuation or the slow control.

The schematic diagram of a relationship between a control threshold and a gain control policy is shown in Fig. 5. The target area is the ideal sampling area of the peaks of the signals, namely the area where the peak of the signal is greater than the slow call-back target threshold and less than the slow attenuation threshold. The slow attenuation threshold returns by a certain reserved amount based on the rapid attenuation threshold, the slow call-back threshold is less than the slow attenuation threshold for a certain adjustment interval, and the slow call-back target threshold is less than the slow attenuation threshold but is greater than the slow call-back threshold. The relative relationship of the rapid attenuation threshold, the slow attenuation threshold, the slow call-back target threshold and the slow call-back threshold is fixed, and the value of each control threshold can be flexibly set according to needs. The values of the rapid attenuation step, the slow attenuation step, the slow call-back step and the super slow call-back step can be set according to the thresholds, so as to ensure that the ping-pong operation will not happen in the process of gain control. For the FDD LTE system, the rapid attenuation threshold, the slow attenuation threshold, the slow call-back threshold, the slow call-back target threshold, the rapid attenuation step, the slow attenuation step, the slow call-back step and the super slow call-back step can be set as -1dBfs, -2.5dBfs, -8dBfs, -5dBfs, 6dB, 2dB, 2dB and 1dB respectively. The target area is [-5dBfs, -2.5dBfs].

After Step 103 is performed, the method further includes:
At Step 104: the gain adjustment amount is compensated by delaying.

Specifically, the data IF processor first delays the gain adjustment amount to align to uplink data at a compensation position, and then compensates the gain adjustment amount to the uplink data by reversed check of gain. Compensating the gain adjustment amount by delaying can ensure the consistency between an antenna aperture power and a baseband power, reduce the influence of baseband demodulation, and improve the performance of a gain control system.

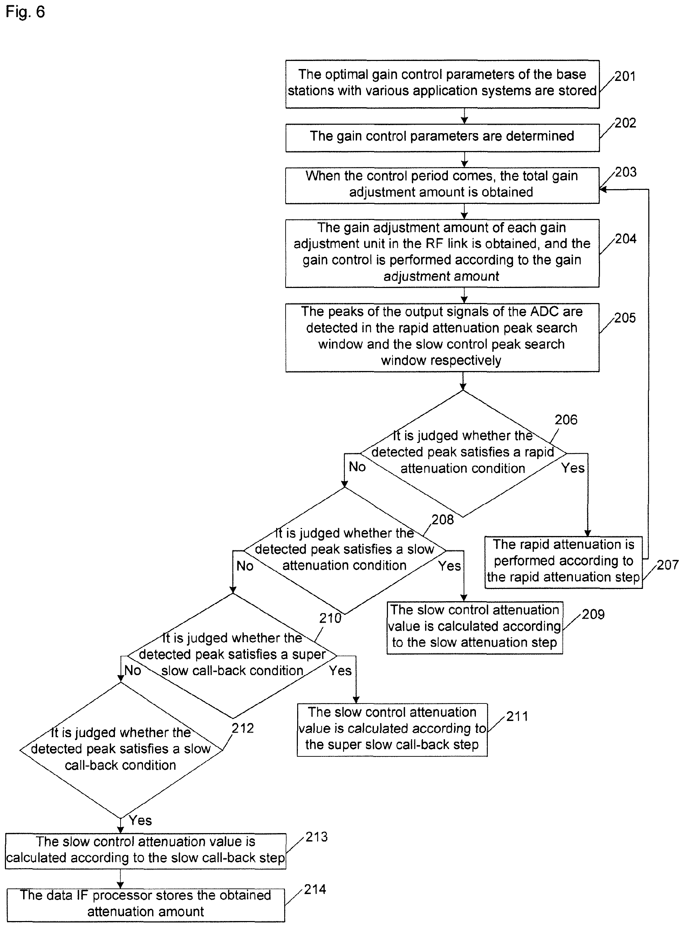

As shown in Fig. 6, the detailed processing flow of the signal gain control method provided by the embodiment of the disclosure includes the following steps.

At Step 201: the optimal gain control parameters of the base stations with various application systems are stored.

Here, the application systems of the base stations include: GSM, UMTS, CDMA, TD-CDMA, TD-LTE, FDD-LTE and various mixed mode systems; the gain control parameters include: the gain control mode, the control period, the control threshold, the adjusting step, the gain control policy, the cumulative number, the adjustment time, and so on.

There are three control periods; the first control period is applied to the time division structure of the GSM system, and is 577us; the second control period is applied to other FDD system except the GSM system, and can be configured as an integral multiple of a subframe; the third control period is applied to the TDD system or the system with the time division interference, and can be configured as an integral multiple of a radio frame.

There are two control modes; the first control mode is the mode containing GSM, and is applied to the GMS system and the mixed mode system containing the GSM system; the second control mode is the mode without GSM, and is applied to the non-GMS system single mode or mixed mode system.

The control thresholds include: the rapid attenuation threshold, the threshold of the number of rapid attenuations, the slow attenuation threshold, the threshold of the number of slow attenuations, the threshold of the number of super slow call-backs, the slow call-back target threshold and the slow call-back threshold; the rapid attenuation threshold is greater than the slow attenuation threshold, the slow attenuation threshold is greater than the slow call-back target threshold, the slow call-back target threshold is greater than the slow call-back threshold.

The adjusting steps include: the rapid attenuation step, the slow attenuation step, the slow call-back step and the super slow call-back step.

The gain control policies include: the rapid attenuation and slow control; the slow control includes: the slow attenuation, the slow call-back and the super slow call-back.

The cumulative numbers include: the cumulative number of excessively rapid attenuation thresholds, the cumulative number of excessively slow attenuation thresholds, and the cumulative number of super slow call-back thresholds; the thresholds of the number include: the threshold of the number of rapid attenuations, the threshold of the number of slow attenuations, and the threshold of the number of super slow call-backs; the threshold of the number of rapid attenuations, the threshold of the number of slow attenuations, and the threshold of the number of super slow call-backs are determined according to the signal characteristic, so as to ensure the judgement accuracy; by calculating the cumulative number, some specific and known large interference signals can be shielded effectively.

The adjustment time includes: the rapid adjustment time and the slow adjustment time; the position of the rapid adjustment time in the control period is not fixed, and is specifically the time of immediately attenuating after a rapid attenuation judgement is effective; the position of the slow adjustment time in the control period is fixed, and is specifically the fixed time point after the start of each control period; the adjustment time is used for performing gain control.

At Step 202: the gain control parameters are determined.

Specifically, when the base station is powered up or the configuration of the base station changes, the data IF processor selects the gain control parameters matching with the application system of the base station from the pre-stored gain control parameters according to the configuration of the base station.

The configuration of the base station includes: the application system, specification and the current carrier configuration information of the base station.

At Step 203: when the control period comes, the total gain adjustment amount is obtained.

Specifically, the data IF processor inquires the total gain adjustment amount stored in the previous control period.

Here, it can be the gain control module in the data IF processor performing above operation.

At Step 204: the gain adjustment amount of each gain adjustment unit in the RF link is obtained, and the gain control is performed according to the gain adjustment amount.

Specifically, the data IF processor inquires, according to the pre-stored attenuation policy table, the gain adjustment amount of each gain adjustment unit which obtains the RF link; the gain adjustment amount of each gain adjustment unit of the RF link in the pre-stored attenuation policy table is calculated according to a saturation point and a noise factor of each device of the RF link.

If the slow control attenuation value is calculated in the previous control period, the gain configuration will be performed according to the calculated slow control attenuation value; if the rapid attenuation is performed in the previous control period, the gain configuration will be performed according to the value of the rapid attenuation in the previous period; if the slow control attenuation value is not calculated in the previous control period and the rapid attenuation is not performed, the gain adjustment amount keeps the effective value of the previous control period; here, it can be the gain control module in the data IF processor performing above operation.

At Step 205: the peaks of the output signals of the ADC are detected in the rapid attenuation peak search window and the slow control peak search window respectively.

Specifically, the data IF processor performs modulus value detection on the output signals of the ADC in the rapid attenuation peak search window and the slow control peak search window.

The rapid attenuation peak search window is the pre-set period of time which is less than the control period, and is used for peak search and peak comparison of the rapid attenuation; the slow attenuation peak search window is another pre-set period of time which is less than the control period, and is used for peak search and peak comparison of the slow attenuation.

Before the peak search and after the response of the device, the data IF processor clears the control parameters; the control parameters include: an initial peak of signal, the cumulative number of excessively rapid attenuation thresholds, the cumulative number of excessively slow attenuation thresholds, the cumulative number of super slow call-back thresholds, and so on.

At Step 206: it is judged whether the detected peak satisfies a rapid attenuation condition; if so, perform Step 207; or else, perform Step 208.

Specifically, in the rapid attenuation peak search window, the data IF processor compares the detected real-time peak with the rapid attenuation threshold, when the detected real-time peak is greater than the rapid attenuation threshold, adds one to the cumulative number of excessively rapid attenuation thresholds; if the cumulative number of excessively rapid attenuation thresholds is equal to the threshold of the number of rapid attenuations, the data IF processor judges that the peak satisfies the rapid attenuation condition; or else, the data IF processor judges that the peak does not satisfy the rapid attenuation condition.

At Step 207: the rapid attenuation is performed according to the rapid attenuation step, and then Step 203 is performed.

Specifically, the data IF processor performs the rapid attenuation according to the rapid attenuation step;
here, the rapid attenuation step is obtained in Step 202.

At Step 208: it is judged whether the detected peak satisfies a slow attenuation condition; if so, perform Step 209; or else, perform Step 210.

Specifically, in the slow attenuation peak search window, the data IF processor compares the detected real-time peak with the slow attenuation threshold, when the detected real-time peak is greater than the slow attenuation threshold, adds one to the cumulative number of excessively slow attenuation thresholds; if the cumulative number of excessively slow attenuation thresholds is greater than the threshold of the number of slow attenuations, and it does not perform the rapid attenuation in the control period at the end of the slow control peak search window, the data IF processor judges that the peak satisfies the slow attenuation condition; or else, the data IF processor judges that the peak does not satisfy the slow attenuation condition.

At Step 209: the slow control attenuation value is calculated according to the slow attenuation step.

Specifically, the slow attenuation step is obtained in Step 202, and the data IF processor performs the slow control at the start of the next control period.

At Step 210: it is judged whether the detected peak satisfies a super slow call-back condition; if so, perform Step 211; or else, perform Step 212.

Specifically, in the slow attenuation peak search window, when the maximum peak detected in continuous N control periods is greater than the slow call-back threshold and less than or equal to the slow call-back target threshold, the data IF processor judges that the detected peak satisfies the super slow call-back condition; or else, the data IF processor judges that the detected peak does not satisfy the super slow call-back condition.

At Step 211: the slow control attenuation value is calculated according to the super slow call-back step.

Specifically, the super slow call-back step is obtained in Step 202, and the data IF processor performs the slow control at the start of the next control period.

At Step 212: it is judged whether the detected peak satisfies a slow call-back condition; if so, perform Step 213; or else, the current attenuation amount remains unchanged.

Specifically, in the slow attenuation peak search window, when the detected maximum peak is less than or equal to the slow call-back threshold, the data IF processor judges that the detected peak satisfies the slow call-back condition; or else, the data IF processor judges that the detected peak does not satisfy the slow call-back condition.

At Step 213: the slow control attenuation value is calculated according to the slow call-back step.

Specifically, the slow call-back step is obtained in Step 202, and the data IF processor performs the slow control at the start of the next control period.

At Step 214: the data IF processor stores the obtained attenuation amount.

In the embodiment of the disclosure, it can be the gain control module in the data IF processor performing the operations of Step 201 to Step 214.

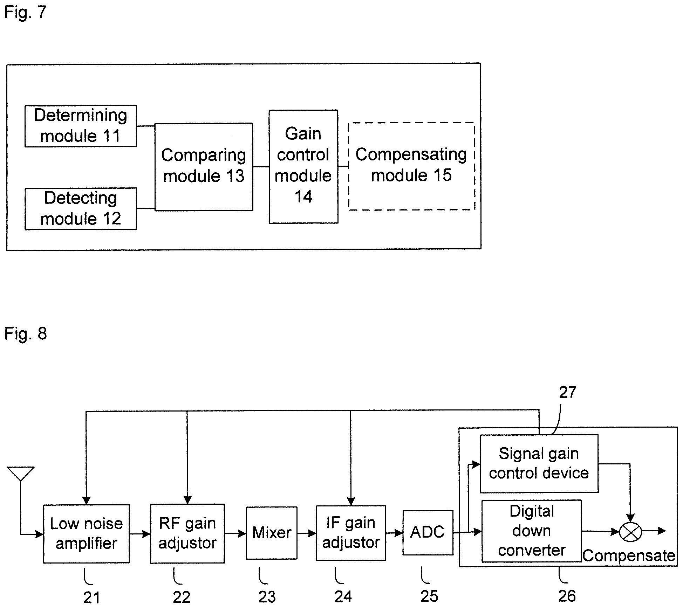

In order to implement the signal gain control method, the embodiment of the disclosure also provides a signal gain control device. As shown in Fig. 7, the structure of the device includes: a determining module 11, a detecting module 12, a comparing module 13 and a gain control module 14; where,
the determining module 11 is configured to determine the gain control parameters;
the detecting module 12 is configured to detect the peaks of the output signals of the ADC in the rapid attenuation peak search window and the slow control peak search window respectively;
the comparing module 13 is configured to compare the detected peaks with the thresholds in the gain control parameters; and
the gain control module 14 is configured to perform the gain control on the signals according to the comparison results.

In an embodiment, the thresholds in the gain control parameters include any one or more of the rapid attenuation threshold, the slow attenuation threshold, the slow call-back threshold and the slow call-back target threshold.

The comparing module is specifically configured to, in the rapid attenuation peak search window, compare the detected real-time peak with the rapid attenuation threshold; and/or, in the slow control peak search window, compare the detected real-time peak with the slow attenuation threshold; and/or, in the slow control peak search window, compare the detected maximum peak with the slow call-back threshold and the slow call-back target threshold.

In an embodiment, the gain control module 14 is specifically configured to, when the detected real-time peak is greater than the rapid attenuation threshold, add one to the number of first excessively peaks, and when the first excessively peak is equal to a threshold of the number of rapid attenuations, perform a rapid attenuation according to the rapid attenuation step; and/or when the detected real-time peak is greater than the slow attenuation threshold, add one to the number of second excessively peaks, and when the second excessively peak is greater than the threshold of the number of slow attenuations, and the rapid attenuation is not performed in the control period at the end of the slow control peak search window, calculate the slow control attenuation value according to the slow attenuation step, and perform the slow control at the start of the next control period; and/or when the detected maximum peak is less than or equal to the slow call-back threshold, calculate the slow control attenuation value according to the slow call-back step in the gain control parameters, and perform the slow control at the start of the next control period; and/or when the maximum peak detected in continuous N control periods is greater than the slow call-back threshold, and is less than or equal to the slow call-back target threshold, calculate the slow control attenuation value according to the super slow call-back step in the gain control parameters, and perform the slow control at the start of the next control period, where N is a positive integer which is greater than or equal to 2.

In an embodiment, the determining module 11 is configured to, when the base station is powered up or the configuration of the base station changes, select the gain control parameters matching with the application system of the base station from the pre-stored gain control parameters according to the configuration of the base station.

In an embodiment, the device further includes: a compensating module 15, which is configured to compensate the gain adjustment amount by delaying.

In an embodiment, the application systems of the base stations include: GSM, UMTS, CDMA, TD-CDMA, TD-LTE, FDD-LTE and various mixed mode systems; the gain control parameters include: the gain control mode, the control period, the control threshold, the adjusting step, the gain control policy, the cumulative number, the adjustment time, and so on.

There are three control periods; the first control period is applied to the time division structure of the GSM system, and is 577us; the second control period is applied to other FDD system except the GSM system, and can be configured as an integral multiple of a subframe; the third control period is applied to the TDD system or the system with the time division interference, and can be configured as an integral multiple of a radio frame.

There are two control modes; the first control mode is the mode containing GSM, and is applied to the GMS system and the mixed mode system containing the GSM system; the second control mode is the mode without GSM, and is applied to the non-GMS system single mode or mixed mode system.

The control thresholds include: the rapid attenuation threshold, the threshold of the number of rapid attenuations, the slow attenuation threshold, the threshold of the number of slow attenuations, the threshold of the number of super slow call-backs, the slow call-back target threshold and the slow call-back threshold; the rapid attenuation threshold is greater than the slow attenuation threshold, the slow attenuation threshold is greater than the slow call-back target threshold, the slow call-back target threshold is greater than the slow call-back threshold.

The adjusting steps include: the rapid attenuation step, the slow attenuation step, the slow call-back step and the super slow call-back step.

The gain control policies include: the rapid attenuation and slow control; the slow control includes: the slow attenuation, the slow call-back and the super slow call-back.

The cumulative numbers include: the cumulative number of excessively rapid attenuation thresholds, the cumulative number of excessively slow attenuation thresholds, and the cumulative number of super slow call-back thresholds; the thresholds of the number include: the threshold of the number of rapid attenuations, the threshold of the number of slow attenuations, and the threshold of the number of super slow call-backs; the threshold of the number of rapid attenuations, the threshold of the number of slow attenuations, and the threshold of the number of super slow call-backs are determined according to the signal characteristic, so as to ensure the judgement accuracy; by calculating the cumulative number, some specific and known large interference signals can be shielded effectively.

The adjustment time includes: the rapid adjustment time and the slow adjustment time; the position of the rapid adjustment time in the control period is not fixed, and is specifically the time of immediately attenuating after the rapid attenuation judgement is effective; the position of the slow adjustment time in the control period is fixed, and is specifically the fixed time point after the start of each control period.

The configuration of the base station includes: the application system, specification and the current carrier configuration information of the base station.

As shown in Fig. 8, the structure of the base station using the signal gain control device provided by the embodiment of the disclosure includes: a low noise amplifier 21, an RF gain adjustor 22, a mixer 23, an IF gain adjustor 24, an ADC 25, a data IF processor 26 and a signal gain control device 27; where,
the low noise amplifier 21 is configured to amplify a signal received by an antenna;
the RF gain adjustor 22 is configured to adjust the amplitude of the signal in an RF part;
the mixer 23 is configured to convert an RF signal containing baseband information into a signal in an IF band and/or a low frequency band, so as to perform further information and signal processing;
the IF gain adjustor 24 is configured to adjust the amplitude of the signal in an IF part;
the ADC 25 is configured to convert an analogue signal into a digital signal;
the data IF processor 26 is configured to perform digital down conversion and IF auxiliary functions;
where, the IF auxiliary functions include: interface conversion, gain control, peak clipping, digital pre-distortion, and so on;
the signal gain control device 27 is configured to determine the gain control parameters, detect the peaks of the output signals of the ADC in the rapid attenuation peak search window and the slow control peak search window respectively, compare the detected peaks with the thresholds in the gain control parameters, and perform gain control on the signals according to the comparison results.

The determining module 11, the detecting module 12, the comparing module 13, the gain control module 14 and the compensating module 15 can be realized by a processor and a logic circuit certainly; the processor can be on the base station; in practical application, the processor can be a Central Processing Unit (CPU), a Micro Processing Unit (MPU), a Digital Signal Processor (DSP), or a Field Programmable Gate Array (FPGA), and so on.

In the embodiment of the disclosure, if the signal gain control method is implemented by software function modules, and the software function modules are sold or used as independent products, they can also be stored in a computer readable storage medium. Based on this understanding, the technical solutions in the embodiments of the disclosure substantially or the part making a contribution to the traditional art can be embodied in the form of software product; the computer software product is stored in a storage medium and includes a number of instructions to make a computer device (which can be a personal computer, a server or a network device, etc.) perform all or part of the method in each embodiment of the disclosure. The above storage medium includes: a USB flash disk, a mobile hard disk, a Read Only Memory (ROM), a magnetic disk or a compact disc, and other media which can store program codes. In this way, the disclosure is not limited to any particular combination of hardware and software.

Correspondingly, the embodiment of the disclosure also provides a computer storage medium, in which a computer program is stored; the computer program is used for performing the above signal gain control method.

The above is only the preferred embodiments of the disclosure and not intended to limit the scope of protection of the disclosure.

## Claims

1. A signal gain control method, comprising:
determining gain control parameters (101);
detecting peaks of output signals of an Analogue to Digital Converter, ADC, in a rapid attenuation peak search window and a slow control peak search window respectively (102); and
comparing the detected peaks with thresholds in the gain control parameters, and performing gain control on the signals according to the comparison results (103);
wherein the thresholds in the gain control parameters comprise any one or more of a rapid attenuation threshold, a slow attenuation threshold, a slow call-back threshold and a slow call-back target threshold;
wherein comparing the detected peaks with the thresholds in the gain control parameters and performing gain control on the signals according to the comparison results comprises:
in the rapid attenuation peak search window, comparing the detected real-time peak with the rapid attenuation threshold, when the detected real-time peak is greater than the rapid attenuation threshold, adding one to a cumulative number of excessively rapid attenuation thresholds, when the cumulative number of excessively rapid attenuation thresholds is equal to a threshold of a number of rapid attenuations, performing a rapid attenuation according to a rapid attenuation step; otherwise,
in the slow control peak search window, comparing the detected real-time peak with the slow attenuation threshold, when the detected real-time peak is greater than the slow attenuation threshold, adding one to a cumulative number of excessively slow attenuation thresholds, when the cumulative number of excessively slow attenuation thresholds is greater than a threshold of a number of slow attenuations and the rapid attenuation is not performed in a control period at the end of the slow control peak search window, calculating a slow control attenuation value according to a slow attenuation step, and performing a slow control at the start of a next control period; otherwise,
in the slow control peak search window, comparing a maximum peak detected with the slow call-back threshold and the slow call-back target threshold, when the maximum peak detected in continuous N control periods is greater than the slow call-back threshold, and is less than or equal to the slow call-back target threshold, calculating the slow control attenuation value according to a super slow call-back step in the gain control parameters, and performing the slow control at the start of the next control period, where N is a positive integer which is greater than or equal to 2; otherwise,
in the slow control peak search window, comparing the maximum peak detected with the slow call-back threshold and the slow call-back target threshold, when the detected maximum peak is less than or equal to the slow call-back threshold, calculating the slow control attenuation value according to a slow call-back step in the gain control parameters, and performing the slow control at the start of the next control period.

2. The signal gain control method according to claim 1, wherein determining the gain control parameters comprises: when a base station is powered up or configuration of a base station changes, selecting the gain control parameters matching with an application system of the base station from the pre-stored gain control parameters according to the configuration of the base station.

3. The signal gain control method according to claim 1, further comprising: compensating gain adjustment amount by delaying.

4. A signal gain control device comprising: a determining module (11), a detecting module (12), a comparing module (13) and a gain control module (14); wherein,
the determining module (11) is configured to determine gain control parameters;
the detecting module (12) is configured to detect peaks of output signals of an Analogue to Digital Converter, ADC, in a rapid attenuation peak search window and a slow control peak search window respectively;
the comparing module (13) is configured to compare the detected peaks with thresholds in the gain control parameters; and
the gain control module (14) is configured to perform gain control on the signals according to the comparison results;
wherein the thresholds in the gain control parameters comprise any one or more of a rapid attenuation threshold, a slow attenuation threshold, a slow call-back threshold and a slow call-back target threshold;
the comparing module is configured to, in the rapid attenuation peak search window, compare the detected real-time peak with the rapid attenuation threshold; and the gain control module is configured to, when the detected real-time peak is greater than the rapid attenuation threshold, add one to a cumulative number of excessively rapid attenuation thresholds, and when the cumulative number of excessively rapid attenuation thresholds is equal to a threshold of a number of rapid attenuations, to perform a rapid attenuation according to a rapid attenuation step; otherwise,
the comparing module is configured to, in the slow control peak search window, compare the detected real-time peak with the slow attenuation threshold; and the gain control module is configured to, when the detected real-time peak is greater than the slow attenuation threshold, add one to a cumulative number of excessively slow attenuation thresholds and when the cumulative number of excessively slow attenuation thresholds is greater than a threshold of a number of slow attenuations, and the rapid attenuation is not performed in a control period at the end of the slow control peak search window, to calculate a slow control attenuation value according to a slow attenuation step, and to perform a slow control at the start of a next control period; otherwise;
the comparing module is configured to, in the slow control peak search window, compare a maximum peak detected with the slow call-back threshold and the slow call-back target threshold, and the gain control module is configured, when the maximum peak detected in continuous N control periods is greater than the slow call-back threshold, and is less than or equal to the slow call-back target threshold, to calculate the slow control attenuation value according to a super slow call-back step in the gain control parameters, and to perform the slow control at the start of the next control period, where N is a positive integer which is greater than or equal to 2; otherwise,
the comparing module is configured to, in the slow control peak search window, compare the maximum peak detected with the slow call-back threshold and the slow call-back target threshold, and the gain control module is configured, when the detected maximum peak is less than or equal to the slow call-back threshold, to calculate the slow control attenuation value according to a slow call-back step in the gain control parameters, and to perform the slow control at the start of the next control period.

5. The signal gain control device according to claim 4, wherein the determining module is configured to, when a base station is powered up or configuration of a base station changes, select the gain control parameters matching with an application system of the base station from the pre-stored gain control parameters according to the configuration of the base station.

6. The signal gain control device according to claim 4, further comprising: a compensating module (15), which is configured to compensate gain adjustment amount by delaying.

7. A computer storage medium, in which a computer executable instruction is stored; the computer executable instruction when executed, performs a signal gain control method according to any one of claims 1 to 3.

## Patentansprüche

1. Signalverstärkungssteuerverfahren, umfassend:
Bestimmen von Verstärkungssteuerparametern (101);
Erfassen von Peaks von Ausgangssignalen eines Analog-Digital-Wandlers, ADC, in einem schnellen Dämpfungspeaksuchfenster bzw. einem langsamen Steuerpeaksuchfenster (102); und
Vergleichen der erfassten Peaks mit Schwellen in den Verstärkungssteuerparametern und Durchführen einer Verstärkungssteuerung mit den Signalen gemäß den Vergleichsergebnissen (103),
wobei die Schwellen in den Verstärkungssteuerparametern jedwede von einer oder mehreren einer schnellen Dämpfungsschwelle, einer langsamen Dämpfungsschwelle, einer langsamen Rückrufschwelle und einer langsamen Rückrufzielschwelle umfassen;
wobei das Vergleichen der erfassten Peaks mit den Schwellen in den Verstärkungssteuerparametern und das Durchführen einer Verstärkungssteuerung mit den Signalen gemäß den Vergleichsergebnissen umfasst:
in dem schnellen Dämpfungspeaksuchfenster, Vergleichen des erfassten Echtzeitpeaks mit der schnellen Dämpfungsschwelle, wobei, wenn der erfasste Echtzeitpeak größer ist als die schnelle Dämpfungsschwelle, eins zu einer kumulativen Zahl von übermäßig schnellen Dämpfungsschwellen addiert wird, wobei, wenn die kumulative Zahl von übermäßig schnellen Dämpfungsschwellen gleich einer Schwelle einer Anzahl von schnellen Dämpfungen ist, eine schnelle Dämpfung gemäß eines schnellen Dämpfungsschritts durchgeführt wird; ansonsten,
in dem langsamen Steuerpeaksuchfenster, Vergleichen des erfassten Echtzeitpeaks mit der langsamen Dämpfungsschwelle, wobei, wenn der erfasste Echtzeitpeak größer ist als die langsame Dämpfungsschwelle, eins zu einer kumulativen Zahl von übermäßig langsamen Dämpfungsschwellen addiert wird, wobei, wenn die kumulative Zahl von übermäßig langsamen Dämpfungsschwellen größer als eine Schwelle einer Anzahl von schnellen Dämpfungen ist und die schnelle Dämpfung nicht in einem Steuerzeitraum am Ende des langsamen Steuerpeaksuchfensters durchgeführt wird, ein langsamer Steuerdämpfungswert gemäß eines langsamen Dämpfungsschritts berechnet wird und eine langsame Steuerung zu Beginn eines nächsten Steuerzeitraums durchgeführt wird; ansonsten
in dem langsamen Steuerpeaksuchfenster, Vergleichen eines maximalen Peaks, der mit der langsamen Rückrufschwelle und der langsamen Rückrufzielschwelle erfasst wird, wobei, wenn der maximale Peak, der in kontinuierlichen N Steuerzeiträumen erfasst wird, größer als die langsame Rückrufschwelle ist und kleiner als die langsame Rückrufzielschwelle oder identisch mit dieser ist, der langsame Steuerdämpfungswert gemäß eines superlangsamen Rückrufschritts in den Verstärkungssteuerparametern berechnet wird und die langsame Steuerung zu Beginn des nächsten Steuerzeitraums durchgeführt wird, wobei N eine positive ganze Zahl ist, die größer als oder gleich 2 ist; ansonsten
in dem langsamen Steuerpeaksuchfenster, Vergleichen des maximalen Peaks, der mit der langsamen Rückrufschwelle und der langsamen Rückrufzielschwelle erfasst wird, wobei, wenn der erfasste maximale Peak kleiner als die langsame Rückrufschwelle oder identisch mit dieser ist, der langsame Steuerdämpfungswert gemäß eines langsamen Rückrufschritts in den Verstärkungssteuerparametern berechnet wird und die langsame Steuerung zu Beginn des nächsten Steuerzeitraums durchgeführt wird.

2. Signalverstärkungssteuerverfahren nach Anspruch 1, bei dem das Bestimmen der Verstärkungssteuerparameter umfasst: wenn eine Basisstation eingeschaltet wird oder sich die Konfiguration einer Basisstation ändert, Auswählen der Verstärkungssteuerparameter, die mit einem Anwendungssystem der Basisstation übereinstimmen, aus den im Vorhinein gespeicherten Steuerparametern gemäß der Konfiguration der Basisstation.

3. Signalverstärkungssteuerverfahren nach Anspruch 1, ferner umfassend: Kompensieren des Verstärkungseinstellausmaßes durch Verzögern.

4. Signalverstärkungssteuervorrichtung, umfassend: ein Bestimmungsmodul (11), ein Erfassungsmodul (12), ein Vergleichsmodul (13) und ein Verstärkungssteuermodul (14); wobei
das Bestimmungsmodul (11) zum Bestimmen von Verstärkungssteuerparametern ausgebildet ist;
das Erfassungsmodul (12) zum Erfassen von Peaks von Ausgangssignalen eines Analog-Digital-Wandlers, ADC, in einem schnellen Dämpfungspeaksuchfenster bzw. einem langsamen Steuerpeaksuchfenster ausgebildet ist;
das Vergleichsmodul (13) zum Vergleichen der erfassten Peaks mit Schwellen in den Verstärkungssteuerparametern ausgebildet ist; und
das Verstärkungssteuermodul (14) zum Durchführen einer Verstärkungssteuerung mit den Signalen gemäß den Vergleichsergebnissen ausgebildet ist;
wobei die Schwellen in den Verstärkungssteuerparametern jedwede von einer oder mehreren einer schnellen Dämpfungsschwelle, einer langsamen Dämpfungsschwelle, einer langsamen Rückrufschwelle und einer langsamen Rückrufzielschwelle umfassen;
wobei das Vergleichen der erfassten Peaks mit den Schwellen in den Verstärkungssteuerparametern und das Durchführen einer Verstärkungssteuerung mit den Signalen gemäß den Vergleichsergebnissen umfasst:
wobei das Vergleichsmodul ausgebildet ist zum, in dem schnellen Dämpfungspeaksuchfenster, Vergleichen des erfassten Echtzeitpeaks mit der schnellen Dämpfungsschwelle, und das Verstärkungssteuermodul ausgebildet ist zum, wenn der erfasste Echtzeitpeak größer ist als die schnelle Dämpfungsschwelle, Addieren von eins zu einer kumulativen Zahl von übermäßig schnellen Dämpfungsschwellen und wenn die kumulative Zahl von übermäßig schnellen Dämpfungsschwellen gleich einer Schwelle einer Anzahl von schnellen Dämpfungen ist, Durchführen einer schnellen Dämpfung gemäß eines schnellen Dämpfungsschritts; ansonsten,
wobei das Vergleichsmodul ausgebildet ist zum, in dem langsamen Steuerpeaksuchfenster, Vergleichen des erfassten Echtzeitpeaks mit der langsamen Dämpfungsschwelle, und das Verstärkungssteuermodul ausgebildet ist zum, wenn der erfasste Echtzeitpeak größer ist als die langsame Dämpfungsschwelle, Addieren von eins zu einer kumulativen Zahl von übermäßig langsamen Dämpfungsschwellen und wenn die kumulative Zahl von übermäßig schnellen Dämpfungsschwellen größer als eine Schwelle einer Anzahl von schnellen Dämpfungen ist und die schnelle Dämpfung nicht in einem Steuerzeitraum am Ende des langsamen Steuerpeaksuchfensters durchgeführt wird, Berechnen eines langsamen Steuerdämpfungswerts gemäß eines langsamen Dämpfungsschritts und Durchführen einer langsamen Steuerung zu Beginn eines nächsten Steuerzeitraums; ansonsten
wobei das Vergleichsmodul ausgebildet ist zum, in dem langsamen Steuerpeaksuchfenster, Vergleichen eines maximalen Peaks, der mit der langsamen Rückrufschwelle und der langsamen Rückrufzielschwelle erfasst wird, und das Verstärkungssteuermodul ausgebildet ist zum, wenn der maximale Peak, der in kontinuierlichen N Steuerzeiträumen erfasst wird, größer als die langsame Rückrufschwelle ist und kleiner als die langsame Rückrufzielschwelle oder identisch mit dieser ist, Berechnen des langsamen Steuerdämpfungswerts gemäß eines superlangsamen Rückrufschritts in den Verstärkungssteuerparametern und Durchführen der langsamen Steuerung zu Beginn des nächsten Steuerzeitraums, wobei N eine positive ganze Zahl ist, die größer als oder gleich 2 ist; ansonsten
wobei das Vergleichsmodul ausgebildet ist zum, in dem langsamen Steuerpeaksuchfenster, Vergleichen des maximalen Peaks, der mit der langsamen Rückrufschwelle und der langsamen Rückrufzielschwelle erfasst wird, und das Verstärkungssteuermodul ausgebildet ist zum, wenn der erfasste maximale Peak kleiner als die langsame Rückrufschwelle oder identisch mit dieser ist, Berechnen des langsamen Steuerdämpfungswerts gemäß eines langsamen Rückrufschritts in den Verstärkungssteuerparametern und Durchführen der langsamen Steuerung zu Beginn des nächsten Steuerzeitraums.

5. Signalverstärkungssteuervorrichtung nach Anspruch 4, bei der das Bestimmungsmodul ausgebildet ist, wenn eine Basisstation eingeschaltet wird oder sich die Konfiguration einer Basisstation ändert, zum Auswählen der Verstärkungssteuerparameter, die mit einem Anwendungssystem der Basisstation übereinstimmen, aus den im Vorhinein gespeicherten Steuerparametern gemäß der Konfiguration der Basisstation.

6. Signalverstärkungssteuervorrichtung nach Anspruch 4, ferner umfassend: ein Kompensationsmodul (15), das zum Kompensieren des Verstärkungseinstellausmaßes durch Verzögern ausgebildet ist.

7. Computerspeichermedium, in dem eine computerausführbare Anweisung gespeichert ist; wobei die computerausführbare Anweisung, wenn sie ausgeführt wird, ein Signalverstärkungssteuerverfahren nach einem der Ansprüche 1 bis 3 ausführt.

## Revendications

1. Procédé de commande de gain de signal, comprenant :
la détermination de paramètres de commande de gain (101) ;
la détection de pics de signaux de sortie d'un convertisseur analogique-numérique, CAN, dans une fenêtre de recherche de pic d'atténuation rapide et une fenêtre de recherche de pic de commande lente respectivement (102) ; et
la comparaison des pics détectés à des seuils dans les paramètres de commande de gain, et la réalisation d'une commande de gain sur les signaux selon les résultats de comparaison (103) ;
dans lequel les seuils dans les paramètres de commande de gain comprennent l'un quelconque ou plusieurs parmi un seuil d'atténuation rapide, un seuil d'atténuation lente, un seuil de rappel lent et un seuil cible de rappel lent ;
dans lequel la comparaison des pics détectés aux seuils dans les paramètres de commande de gain et la réalisation d'une commande de gain sur les signaux selon les résultats de comparaison comprennent :
dans la fenêtre de recherche de pic d'atténuation rapide, la comparaison du pic temps réel détecté au seuil d'atténuation rapide, lorsque le pic temps réel détecté est supérieur au seuil d'atténuation rapide, l'addition de un à un nombre cumulé de seuils d'atténuation excessivement rapide, lorsque le nombre cumulé de seuils d'atténuation excessivement rapide est égal à un seuil d'un nombre d'atténuations rapides, la réalisation d'une atténuation rapide selon une étape d'atténuation rapide ; sinon,
dans la fenêtre de recherche de pic de commande lente, la comparaison du pic temps réel détecté au seuil d'atténuation lente, lorsque le pic temps réel détecté est supérieur au seuil d'atténuation lente, l'addition de un à un nombre cumulé de seuils d'atténuation excessivement lente, lorsque le nombre cumulé de seuils d'atténuation excessivement lente est supérieur à un seuil d'un nombre d'atténuations lentes et l'atténuation rapide n'est pas réalisée dans une période de commande à la fin de la fenêtre de recherche de pic de commande lente, le calcul d'une valeur d'atténuation de commande lente selon une étape d'atténuation lente, et la réalisation d'une commande lente au début d'une prochaine période de commande ; sinon,
dans la fenêtre de recherche de pic de commande lente, la comparaison d'un pic maximum détecté au seuil de rappel lent et au seuil cible de rappel lent, lorsque le pic maximum détecté dans N périodes de commande continues est supérieur au seuil de rappel lent, et est inférieur ou égal au seuil cible de rappel lent, le calcul de la valeur d'atténuation de commande lente selon une étape de rappel super lent dans les paramètres de commande de gain, et la réalisation de la commande lente au début de la prochaine période de commande, où N est un nombre entier positif qui est supérieur ou égal à 2 ; sinon,
dans la fenêtre de recherche de pic de commande lente, la comparaison du pic maximum détecté au seuil de rappel lent et au seuil cible de rappel lent, lorsque le pic maximum détecté est inférieur ou égal au seuil de rappel lent, le calcul de la valeur d'atténuation de commande lente selon une étape de rappel lent dans les paramètres de commande de gain, et la réalisation de la commande lente au début de la prochaine période de commande.

2. Procédé de commande de gain de signal selon la revendication 1, dans lequel la détermination des paramètres de commande de gain comprend : lorsqu'une station de base est mise sous tension ou une configuration d'une station de base change, la sélection des paramètres de commande de gain concordant avec un système d'application de la station de base parmi les paramètres de commande de gain préstockés selon la configuration de la station de base.

3. Procédé de commande de gain de signal selon la revendication 1, comprenant en outre : la compensation d'une quantité d'ajustement de gain par retard.

4. Dispositif de commande de gain de signal comprenant : un module de détermination (11), un module de détection (12), un module de comparaison (13) et un module de commande de gain (14) ; dans lequel,
le module de détermination (11) est configuré pour déterminer des paramètres de commande de gain ;
le module de détection (12) est configuré pour détecter des pics de signaux de sortie d'un convertisseur analogique-numérique, CAN, dans une fenêtre de recherche de pic d'atténuation rapide et une fenêtre de recherche de pic de commande lente, respectivement ;
le module de comparaison (13) est configuré pour comparer les pics détectés à des seuils dans les paramètres de commande de gain ; et
le module de commande de gain (14) est configuré pour réaliser une commande de gain sur les signaux selon les résultats de comparaison ;
dans lequel les seuils dans les paramètres de commande de gain comprennent l'un quelconque ou plusieurs parmi un seuil d'atténuation rapide, un seuil d'atténuation lente, un seuil de rappel lent et un seuil cible de rappel lent ;
le module de comparaison est configuré, dans la fenêtre de recherche de pic d'atténuation rapide, pour comparer la pic temps réel détecté au seuil d'atténuation rapide ; et le module de commande de gain est configuré, lorsque le pic temps réel détecté est supérieur au seuil d'atténuation rapide, pour additionner un à un nombre cumulé de seuils d'atténuation excessivement rapide, et lorsque le nombre cumulé de seuils d'atténuation excessivement rapide est égal à un seuil d'un nombre d'atténuations rapides, pour réaliser une atténuation rapide selon une étape d'atténuation rapide ; sinon,
le module de comparaison est configuré, dans la fenêtre de recherche de pic de commande lente, pour comparer le pic temps réel détecté au seuil d'atténuation lente ; et le module de commande de gain est configuré, lorsque le pic temps réel détecté est supérieur au seuil d'atténuation lente, pour additionner un à un nombre cumulé de seuils d'atténuation excessivement lente et lorsque le nombre cumulé de seuils d'atténuation excessivement lente est supérieur à un seuil d'un nombre d'atténuations lentes, et l'atténuation rapide n'est pas réalisée dans une période de commande à la fin de la fenêtre de recherche de pic de commande lente, pour calculer une valeur d'atténuation de commande lente selon une étape d'atténuation lente, et pour réaliser une commande lente au début d'une prochaine période de commande ; sinon,
le module de comparaison est configuré, dans la fenêtre de recherche de pic de commande lente, pour comparer un pic maximum détecté au seuil de rappel lent et au seuil cible de rappel lent, et le module de commande de gain est configuré, lorsque le pic maximum détecté dans N périodes de commande continues est supérieur au seuil de rappel lent, et est inférieur ou égal au seuil cible de rappel lent, pour calculer la valeur d'atténuation de commande lente selon une étape de rappel super lent dans les paramètres de commande de gain, et pour réaliser la commande lente au début de la prochaine période de commande, où N est un nombre entier positif qui est supérieur ou égal à 2 ; sinon,
le module de comparaison est configuré, dans la fenêtre de recherche de pic de commande lente, pour comparer le pic maximum détecté au seuil de rappel lent et au seuil cible de rappel lent, et le module de commande de gain est configuré, lorsque le pic maximum détecté est inférieur ou égal au seuil de rappel lent, pour calculer la valeur d'atténuation de commande lente selon une étape de rappel lent dans les paramètres de commande de gain, et pour réaliser la commande lente au début de la prochaine période de commande.

5. Dispositif de commande de gain de signal selon la revendication 4, dans lequel le module de détermination est configuré, lorsqu'une station de base est mise sous tension ou une configuration d'une station de base change, pour sélectionner les paramètres de commande de gain concordant avec un système d'application de la station de base parmi les paramètres de commande de gain préstockés selon la configuration de la station de base.

6. Dispositif de commande de gain de signal selon la revendication 4, comprenant en outre : un module de compensation (15), qui est configuré pour compenser une quantité d'ajustement de gain par retard.

7. Support de stockage par ordinateur, dans lequel une instruction exécutable par ordinateur est stockée ; l'instruction exécutable par ordinateur, lorsqu'elle est exécutée, réalise un procédé de commande de gain de signal selon l'une quelconque des revendications 1 à 3.
